# EUROPÄISCHE PATENTSCHRIFT

(11) **EP 0 482 387 B1**
(45) Veröffentlichungstag und Bekanntmachung des Hinweises auf die Patenterteilung: **30.08.1995**
(21) Anmeldenummer: 91116711.2
(22) Anmeldetag: 30.09.1991
(51) Int. Cl.: C30B 29/22, C30B 23/02

(54) **Verfahren zur Herstellung einer supraleitenden Schicht aus YBa2Cu3O7 auf einem Substrat aus Saphir**
Process for producing a YBa2Cu3O7 superconducting layer on a sapphire substrate
Procédé pour la fabrication de couches supraconductrices de YBaCu3O7 sur un substrat de saphir

(30) Priorität: 26.10.1990 DE 4034168
(43) Veröffentlichungstag der Anmeldung: 29.04.1992
(73) Patentinhaber: SIEMENS AKTIENGESELLSCHAFT, 80333 München (DE)
(72) Erfinder: Schmidt, Harald, Dr., W-8000 München 83 (DE); Wersing, Wolfram, W-8011 Kirchheim (DE); Hradil, Klaudia, W-8000 München 90 (DE)

(56) Entgegenhaltungen:
- EP-A- 0 364 068
- APPLIED PHYSICS LETTERS, Bd. 59, Nr. 2, 8. Juli 1991, NEW YORK, US, Seiten 222-224; SCHMIDT ET AL: 'EPITAXIAL YBA2CU3OX THIN FILMS ON SAPPHIRE USING A Y-STABILIZED ZRO2 BUFFER LAYER"
- PATENT ABSTRACTS OF JAPAN, vol. 14, no. 137 (C-0702), 15. März 1990; & JP-A-2 011 751
- JAPANESE JOURNAL OF APPLIED PHYSICS, Bd. 28, Nr. 3, Mai 1989, TOKYO, JP, Seiten 351-355; MYOREN: "AS-GROWN PREPARATION OF SUPERCONDUCTING EPITAXIAL BA2YCU30X THIN FILMS SPUTTERED ON EPITAXIALLY GROWN ZRO2/SI(100)"
- MATER. RES. SOC. SYMP. PROC, Bd. 56, 1986, OXFORD, GB, Seiten 259-264; KONUSHI: "EPITAXIAL GROWTH OF ZIRCONIA AND YTTRIA STABILIZED ZIRCONIA FILMS ON SAPPHIRE SUBSTRATES BY REACTIVE SPUTTERING"
- APPLIED PHYSICS LETTERS, Bd. 53, Nr. 8, 22. August 1988, NEW YORK, US, Seiten 698-699; HESS: "PREPARATION AND PATTERNINIG OF YBACUO THIN FILMS OBTAINED BY SEQUENTIAL DEPOSITION OF CUOX/Y2O3/BAF2"
- VIDE, LES COUCHES MINCES, Bd. 45, Nr. 252, Juli 1990, PARIS, FR, Seiten 170-171; BOUCHER: "COMPARAISON DE L'ABLATION DE FILMS YBA2CU3O7-X A PARTIR DE MONOCIBLES"

## Beschreibung

Supraleitende Schichten aus YBa₂Cu₃O₇ hoher Güte auf Substraten aus Saphir werden z. B. bei der Herstellung von Mikrowellenvorrichtungen benötigt.

Bei der Herstellung von supraleitenden Schichten aus YBa₂Cu₃O₇ auf einem Substrat aus Saphir durch Direktabscheidung der supraleitenden Schicht auf dem Substrat besteht die Gefahr einer Diffusion des Aluminiums aus dem Saphir durch die supraleitende Schicht. Die Temperatur des Substrats muß daher bei der Abscheidung so niedrig gehalten werden, daß diese Diffusion unterbleibt.

Die Abscheidung bei niedrigen Temperaturen des Substrats hat jedoch den Nachteil, daß die supraleitende Schicht eine mangelhafte Kristallperfektion aufweist. Die Kristallperfektion ist zu schlecht, um gute supraleitende Kenndaten, wie Sprungtemperatur T_{c} und kritische Stromdichte J_{c}, zu liefern.

Es ist bekannt (s. z. B. K. Char et al., Appl. Phys. Lett. 57, 1990, p. 409 - 411), das Diffusionsproblem dadurch zu lösen, daß auf das Substrat unter die supraleitende Schicht eine Zwischenschicht aufgebracht wird. Die Zwischenschicht muß dabei epitaktisch auf dem Substrat aus Saphir aufwachsen. Darüberhinaus muß ein epitaktisches Wachsen der supraleitenden Schicht auf der Zwischenschicht möglich sein. Die Zwischenschicht muß bezüglich ihrer Gitterkonstanten daher einerseits auf die Gitterstruktur des Substrats aus Saphir und andererseits auf die Gitterstruktur der supraleitenden Schicht aus YBa₂Cu₃O₇ angepaßt sein.

In K. Char et al., Appl. Phys. Lett. 57, 1990, p. 409 - 411 wird eine Zwischenschicht aus SrTiO₃ auf einem Substrat aus Saphir unter einer supraleitenden Schicht aus YBa₂Cu₃O₇ untersucht. Dabei wurde eine kritische Stromdichte von 2 x 10⁶ A/cm² bei 74 K erreicht.

Aus einem Artikel von Myoren et al in Japanese Journal of Applied Physics, Bd. 28, Nr. 3, Mai 1989, Tokyo, Seiten 351 bis 355 ist es bekannt, epitaxiale YBa₂Cu₃Oₓ-Dünnschichten auf einem monokristallinen Siliziumsubstrat mit Hilfe einer yttriumstabilisierten Zirkonoxidzwischenschicht abzuscheiden.

Aus einem Artikel von Hess et al in Applied Physics Letters, Bd. 53, Nr. 8, 22. August 1988, New York, Seiten 698 bis 699 ist die Herstellung einer YBa₂Cu₃Oₓ-Supraleiterschicht über einem Saphirsubstrat und einer yttriumstabilisierten Zirkonoxidzwischenschicht bekannt.

Aus Boucher et al in Le Vide, Les Couches Minces, Bd. 45, Nr. 252, Juli 1990, Paris, Seiten 170 bis 171 ist das Herstellen supraleitender Dünnschichten aus YBa₂Cu₃Oₓ bekannt, wobei ein Saphirsubstrat mit einer Pufferschicht aus yttriumstabilisiertem Zirkonoxid verwendet wird.

Aus EP-A 0 364 068 ist ein Verfahren zum Herstellen des borhaltigen Supraleiters YB₂Cu₃O₇ über einem Saphirsubstrat und einer monokristallinen Pufferschicht aus Zirkonoxid bekannt.

Der Erfindung liegt das Problem zugrunde, ein weiteres Herstellverfahren zur Herstellung einer supraleitenden Schicht aus YBa₂Cu₃O₇ auf einem Substrat aus Saphir anzugeben, mit dem eine weitere Verbesserung der supraleitenden Kenndaten der supraleitenden Schicht erzielbar ist.

Die Erfindung wird gelöst durch ein Verfahren nach Anspruch 1.

Aus F. Konushi et al., Mater. Res. Soc. Symp. Proc. 56, 1986, p. 259 - 264 ist eine Untersuchung von Schichten aus Zirkonoxid bzw. aus yttriumstabilisierten Zirkonoxid, die auf Saphirsubstrat aufgewachsen sind, im Hinblick auf SOI-An-ordnungen bekannt. Die Untersuchung hat ergeben, daß die Kristallinität von Zirkonoxid bzw. yttriumstabilisiertem Zirkonoxid befriedigend ist.

Die Erfindung macht sich diese Erkenntnis zur Herstellung einer supraleitenden Schicht aus YBa₂Cu₃O₇ auf einem Substrat aus Saphir zu nutze. Auf diese Weise hergestellte supraleitende Schichten aus YBa₂Cu₃O₇ zeigen Sprungtemperaturen von 84 K. Eine weitere Verbesserung der supraleitenden Kenndaten der supraleitenden Schicht wird dadurch erreicht, daß auf die yttriumstabilisierte Zirkonoxidschicht eine Yttriumoxidschicht epitaktisch aufgewachsen wird, auf die dann die supraleitende Schicht aus YBa₂Cu₃O₇ abgeschieden wird.

Es liegt im Rahmen der Erfindung, die Zwischenschicht auf die R-plane des Substrats aufzuwachsen. Die R-plane entspricht der (11̅02)-Ebene.

In dem erfindungsgemäßen Herstellverfahren muß die Temperatur des Substrates hoch genug sein, damit ein epitaktisches Wachstum sowohl der Zwischenschichten als auch der supraleitenden Schicht darauf gewährleistet ist.

Die Zwischenschicht wird mit einem Verfahren zur Abscheidung von Dünnfilmen aufgebracht. Insbesondere sind CVD-Verfahren, Aufdampfen, z.B. mittels Elektronenstrahlen, Sputterverfahren, z.B. DC-Sputtern oder Laserdeposition, geeignet. Besonders gute Ergebnisse werden erzielt, wenn die Zwischenschicht bei einer Temperatur des Substrates von mindestens 700°C durch RF-Magnetron-Sputtern aufgebracht wird.

Die supraleitende Schicht wird ebenfalls mit einem Verfahren zur Abscheidung von Dünnfilmen aufgebracht. Insbesondere sind CVD-Verfahren, Aufdampfen, z.B. mittels Elektronenstrahlen, Sputterverfahren, z.B. DC-Sputtern oder Laserdeposition, geeignet. Es ist jedoch vorteilhaft, die supraleitende Schicht in demselben Reaktor wie die Zwischenschicht durch RF-Magnetron-Sputtern aufzubringen, da in diesem Fall die Probe dem Reaktor nicht entnommen werden muß und dadurch Kontaminationsprobleme an der Grenzfläche vermieden werden.

Im weiteren wird die Erfindung anhand der Figuren und der Ausführungsbeispiele näher erläutert.
- Fig. 1: zeigt ein Substrat aus Saphir mit einer Zwischenschicht aus yttriumstabilisiertem Zirkonoxid und einer supraleitenden Schicht aus YBa₂Cu₃O₇.
- Fig. 2: zeigt ein Substrat aus Saphir mit einer aus einer Yttriumoxidschicht und einer yttriumstabilisierten Zirkonoxidschicht zusammengesetzten Zwischenschicht und einer supraleitenden Schicht aus YBa₂Cu₃O₇.

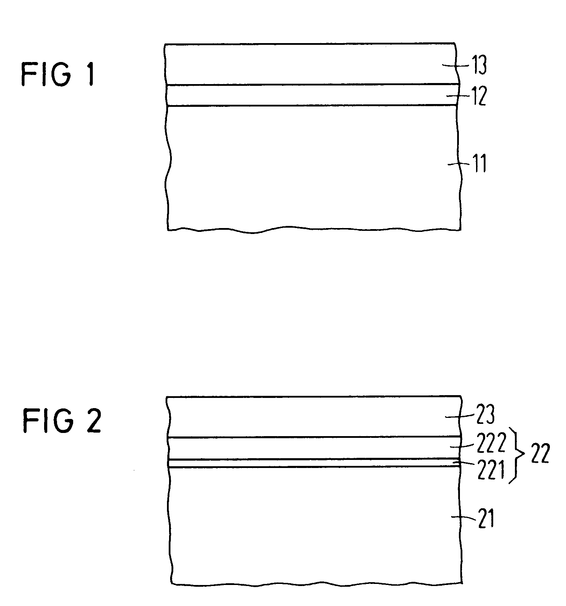

Auf ein Substrat 11 aus Saphir wird epitaktisch eine Zwischenschicht 12 aufgewachsen. Dabei wird als Substrat 11 z. B. eine Scheibe verwendet, die eine Dicke von etwa 0,5 - 1 mm aufweist und deren Oberfläche der kristallographischen R-plane (das entspricht der (11̅02)-Ebene) parallel ist (s. Fig. 1). Die Zwischenschicht 12 wird z. B. durch RF-Magnetron-Sputtern bei einer Temperatur des Substrats 11 von mindestens 700 °C aufgewachsen. Die Zwischenschicht 12 besteht dabei aus yttriumstabilisiertem Zirkonoxid und wird in einer Dicke von z. B. 50 - 100 nm aufgewachsen. Der Bestandteil an Yttriumoxid in dem yttriumstabilisierten Zirkonoxid beträgt z. B. 12 At %. .

Mit Hilfe von Channeling (RBS) wurde nachgewiesen, daß die Zwischenschicht 12 unter den angegebenen Bedingungen epitaktisch aufwächst. Zur Abscheidung der Zwischenschicht 12 wurden folgende Parameter eingehalten:
- Sputtergas:: Ar/O₂-Gemisch mit 10 % O₂
- Sputterdruck:: 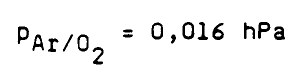
- Substrattemperatur:: mindestens 700°C.

Auf die Zwischenschicht 12 wird anschließend eine supraleitende Schicht 13 epitaktisch aufgewachsen. Die supraleitende Schicht besteht aus YBa₂Cu₃O₇ und weist eine Dicke von etwa 500 nm auf.

Die supraleitende Schicht 13 wird z. B. ebenfalls durch RF-Magnetron-Sputtern bei Substrattemperaturen über 700 °C aufgewachsen. Das hat den Vorteil, daß sowohl die Zwischenschicht 12 als auch die supraleitende Schicht 13 in demselben Reaktor herstellbar sind. Es muß lediglich nach der Herstellung der Zwischenschicht 12 in dem Reaktor auf ein anderes Sputtertarget umgeschaltet werden.

Es liegt ebenfalls im Rahmen der Erfindung, die supraleitende Schicht 13 auf die zuvor durch RF-Magnetron-Sputtern abgeschiedene Zwischenschicht 12 in einem anderen Reaktor durch Laserdeposition aufzuwachsen.

In einer zweiten Ausführungsform der Erfindung wird auf ein Substrat 21 aus Saphir (R-plane) eine yttriumstabilisierte Zirkonoxidschicht 221 abgeschieden (s. Fig. 2). Die yttriumstabilisierte Zirkonoxidschicht 221 wird in einer Dicke von z. B. 50 - 100 nm abgeschieden. Auf die yttriumstabilisierte Zirkonoxidschicht 221 wird eine Yttriumoxidschicht 222 in einer Dicke von z. B. 50 - 100 nm abgeschieden. Die yttriumstabilisierte Zirkonoxidschicht 221 und die Yttriumoxidschicht 222 bilden gemeinsam eine Zwischenschicht 22 auf dem Substrat 21. Auf die Zwischenschicht 22 wird eine supraleitende Schicht 23 aus YBa₂Cu₃O₇ aufgewachsen. Die supraleitende Schicht 23 weist eine Dicke von ca. 500 nm auf. Die Abscheidung der Zwischenschicht 22 und der supraleitenden Schicht 23 erfolgt z. B. mittels RF-Magnetron-Sputtern bei Substrattemperaturen von mindestens 700 °C.

Durch Verwendung einer zusammengesetzten Zwischenschicht 22 wird eine weitere Verbesserung der Kristallinität der supraleitenden Schicht 23 erzielt.

Für die Abscheidung der Zwischenschicht 22 und der supraleitenden Schicht 23 wurden folgende Parameter eingestellt:
für die yttriumstabilisierte Zirkonoxidschicht 221:
- Sputtergas:: Ar/O₂-Gemisch mit 10 % O₂ 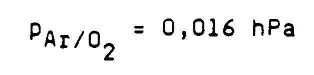
- Sputtertemperatur:: mindestens 700°C
für die Yttriumoxidschicht 222:
- Sputtergas:: Ar/O₂-Gemisch mit 50 % O₂ 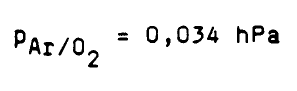
- Sputtertemperatur:: mindestens 700°C
für die supraleitende Schicht 23 aus YBa₂Cu₃O₇:
- Sputtergas:: Ar/O₂-Gemisch mit 30 % O₂ 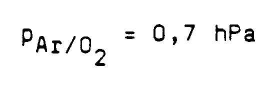
- Sputtertemperatur:: mindestens 700°C.

## Patentansprüche

1. Verfahren zur Herstellung einer supraleitenden Schicht aus YBa₂Cu₃O₇ auf einem Substrat aus Saphir mit folgenden Schritten:
a) auf das Substrat (11, 21) wird epitaktisch eine Zwischenschicht (12, 22) aufgewachsen, wobei die Zwischenschicht (22) dadurch erzeugt wird, daß auf die Oberfläche des Substrats (21) epitaktisch eine yttriumstabilisierte Zirkonoxidschicht (221) aufgewachsen wird und auf die yttriumstabilisierte Zirkonoxidschicht (221) epitaktisch eine Yttriumoxidschicht (222) aufgewachsen wird,
b) auf die Zwischenschicht (12, 22) wird die supraleitende Schicht (13, 23) aufgebracht,
c) das Substrat (11, 21) wird auf eine Temperatur aufgeheizt, bei der das Wachstum der Zwischenschicht (12, 22) und der supraleitenden Schicht (13, 23) epitaktisch erfolgt.

2. Verfahren nach Anspruch 1,
bei dem die Zwischenschicht (12, 22) auf die R-plane des Substrates (11, 21) aufgewachsen wird.

3. Verfahren nach einem der Ansprüche 1 oder 2,
bei dem die Zwischenschicht (12, 22) durch RF-Magnetron-Sputtern aufgebracht wird.

4. Verfahren nach Anspruch 3,
bei dem die supraleitende Schicht (13, 23) durch RF-Magnetron-Sputtern aufgebracht wird.

5. Verfahren nach einem der Ansprüche 1 bis 4,
bei dem die Verfahrensschritte a) und b) bei einer Temperatur von je mindestens 700°C durchgeführt werden.

## Claims

1. Method of producing a superconducting layer of YBa₂Cu₃O₇ on a sapphire substrate, comprising the following steps:
a) an interlayer (12, 22) is grown epitaxially on the substrate (11, 21), the interlayer (22) being generated by growing an yttrium-stabilized zirconium oxide layer (221) epitaxially on the surface of the substrate (21) and growing an yttrium oxide layer (222) epitaxially on the yttrium-stabilized zirconium oxide layer (221),
b) the superconducting layer (13, 23) is applied to the interlayer (12, 22),
c) the substrate (11, 21) is heated to a temperature at which the growth of the interlayer (12, 22) and of the superconducting layer (13, 23) takes place epitaxially.

2. Method according to Claim 1, in which the interlayer (12, 22) is grown on the R-plane of the substrate (11, 21).

3. Method according to one of Claims 1 or 2, in which the interlayer (12, 22) is applied by RF-magnetron sputtering.

4. Method according to Claim 3, in which the superconducting layer (13, 23) is applied by RF-magnetron sputtering.

5. Method according to one of Claims 1 to 4, in which the method steps a) and b) are carried out at a temperature of at least 700°C in each case.

## Revendications

1. Procédé pour fabriquer une couche supraconductrice formée de YBa₂Cu₃O₇ sur un substrat en saphir, au moyen des étapes suivantes :
a) sur le substrat (11,21), on fait croître par épitaxie une couche intermédiaire (12,22), la couche intermédiaire (22) étant produite par le fait que sur la surface du substrat (21) on fait croître par épitaxie une couche d'oxyde de zircone (221) stabilisée par de l'yttrium et qu'on fait croître par épitaxie une couche d'oxyde d'yttrium (222) sur la couche d'oxyde de zircone (221) stabilisée par de l'yttrium,
b) on dépose la couche supraconductrice (13,23) sur la couche intermédiaire (12,22),
c) on chauffe le substrat (11,21) à une température, pour laquelle la croissance de la couche intermédiaire (12,22) et de la couche supraconductrice (13,23) s'effectue de façon épitaxiale.

2. Procédé selon la revendication 1, selon lequel on fait croître la couche intermédiaire (12,22) sur le plan R du substrat (11,21).

3. Procédé selon l'une des revendications 1 ou 2, selon lequel on dépose la couche intermédiaire (12,22) au moyen d'une pulvérisation HF par magnétron.

4. Procédé selon la revendication 3, selon lequel on dépose la couche supraconductrice (13,23) au moyen d'une pulvérisation HF par magnétron.

5. Procédé selon l'une des revendications 1 à 4, selon lequel on exécute les étapes opératoires a) et b) à une température égale respectivement au moins à 700°C.
